# EUROPÄISCHE PATENTSCHRIFT

(11) **EP 1 451 872 B1**
(45) Veröffentlichungstag und Bekanntmachung des Hinweises auf die Patenterteilung: **07.03.2007**
(21) Anmeldenummer: 02740176.9
(22) Anmeldetag: 24.06.2002
(51) Int. Cl.: H05K 1/00, H05K 1/02, H01L 25/075, G09F 9/33

(54) **LEUCHTDIODEN-LEUCHTPANEEL UND LEITERPLATTE**
LIGHT EMITTING DIODE-BASED LUMINOUS PANEL AND CARRIER PLATE
PANNEAU LUMINESCENT A DIODES ELECTROLUMINESCENTES ET PLAQUE SUPPORT

(30) Priorität: 13.09.2001 CH 170001
(43) Veröffentlichungstag der Anmeldung: 01.09.2004
(73) Patentinhaber: Lucea AG, 6302 Zug (CH)
(72) Erfinder: STAUFERT, Gerhard, CH-4800 Zofingen (CH)
(74) Vertreter: Dreykorn-Lindner, Werner
(86) Internationale Anmeldenummer: PCT/CH2002/000339
(87) Internationale Veröffentlichungsnummer: WO 2003/023857

(56) Entgegenhaltungen:
- EP-A- 1 081 771
- WO-A-99/41785
- WO-A-99/57951
- DE-A- 19 926 746
- US-A- 4 935 665
- US-A- 5 278 432
- US-A- 5 698 866
- PATENT ABSTRACTS OF JAPAN Bd. 010, Nr. 343 (E-456), 19. November 1986 (1986-11-19) & JP 61 145877 A (MITSUBISHI ELECTRIC CO), 3. Juli 1986 (1986-07-03)
- PATENT ABSTRACTS OF JAPAN Bd. 1996, Nr. 05, 31. Mai 1996 (1996-05-31) -& JP 08 008463 A (SHARP CORP), 12. Januar 1996 (1996-01-12)
- PATENT ABSTRACTS OF JAPAN Bd. 013, Nr. 317 (E-789), 19. Juli 1989 (1989-07-19) -& JP 01 086573 A (HAMAMATSU KK ET AL), 31. März 1989 (1989-03-31)
- PATENT ABSTRACTS OF JAPAN Bd. 008, Nr. 036 (E-227), 16. Februar 1984 (1984-02-16) -& JP 58 194383 A (SUMITOMO DENKI KOGYO), 12. November 1983 (1983-11-12)

## Beschreibung

Die Erfindung betrifft ein konfektionierbares Leuchtpaneel mit lichtemittierenden Dioden, sowie eine Leiterplatte als Bauelement eines solchen, gemäss dem Oberbegriff der unabhängigen Patentansprüche.

Aus dem Dokument WO 9 941 785 A1 ist ein konfektionierbares, lichtemittierendes Paneel bekannt, das es ermöglicht, ungehäuste Leuchtdioden (LED-Chips) gruppenweise seriell und parallel zu verschalten. Der Aufbau des Paneels und die Verschaltung der LEDs ist so ausgelegt, dass das Paneel als beliebig grosse Fläche gefertigt werden kann. Diese Fläche kann in beliebig geformte Teilstücke zertrennt werden, solange die Grösse dieser Teilstücke eine bestimmte kleinste funktionsfähige Untereinheit nicht unterschreitet. Die Verwendung von ungehäusten LED-Chips erlaubt eine wahlweise lockere oder dichte Anordnung von LEDs. Insbesondere wird eine dichtere Anordnung als bei herkömmlichen Paneelen mit gehäusten Leuchtdioden ermöglicht. In herkömmlichen Leuchtpaneelen erreicht die LED Dichte, je nach Kühlung, typische Werte im Bereich von ca. 4-9 LED/cm². Das Paneel des Dokuments WO 9 941 785 A1 kann ohne weiteres mit 25 LED/cm² bestückt werden.

JP08008463A offenbart ein Leuchtpaneel mit einer Trägerplatte, aufweisend eine elektrisch leitende Unterlage, eine elektrisch isolierende Schicht mit einem Raster von ersten Öffnungen, eine erste elektrisch leitende Schicht, und eine von der Unterlage und der ersten Schicht isolierte zweite elektrisch leitende Schicht mit einem Raster von zweiten Öffnungen, welche die ersten Öffnungen umfassen und grösser sind als diese.

Ausgehend vom Paneel des Dokuments WO 9 941 785 A1 soll nun ein Leuchtpaneel entwickelt werden, dessen Herstellung weiter vereinfacht wird. Insbesondere sollte kein aufwändiges Kontaktieren von LEDs erfolgen müssen. Die Herstellungskosten sollen insgesamt gesenkt werden. Ausserdem sollte die Flexibilität des Paneels noch weiter erhöht werden. Insbesondere wäre es wünschenswert, wenn eine noch dichtere Anordnung von LEDs möglich wäre.

Diesen Weg geht die Erfindung.

Die Erfindung, wie sie in den Patentansprüchen definiert ist, stellt ein Leuchtpaneel zur Verfügung, welches tatsächlich einfach in der Herstellung ist und sich auch als kostengünstiges Massenprodukt eignet. Ausserdem ist eine Leiterplatte als Baustein eines solchen Paneels Gegenstand der Erfindung.

Das erfindungsgemässe konfektionierbare lichtemittierende Paneel beinhaltet parallel geschaltete kleinste Untereinheiten mit je mindestens zwei seriell geschaltete, durch Elektrizität betreibbare Leuchtkörper, nämlich Leuchtdiodenchips. Das Leuchtpaneel ist nachträglich in für sich funktionsfähige Teilstücke mit mindestens der Grösse einer kleinsten Untereinheit zertrennbar. Es weist eine Unterlage mit einer elektrisch leitenden Oberfläche und eine von dieser Oberfläche durch eine elektrisch isolierende Schicht getrennte elektrisch leitende Schicht (Deckschicht) auf, wobei die Unterlage und die Deckschicht als Anschlussflächen zum elektrisch parallelen Kontaktieren der Untereinheiten fungieren. Die elektrisch isolierende Schicht weist ein regelmässiges Raster von ersten Öffnungen auf. Von der Unterlage elektrisch isolierte, regelmässig gitterartig angeordnete Leiterbahnen dienen zur elektrischen Verbindung der verschiedenen Leuchtkörper der, einzelnen Untereinheiten und sind von den elektrischen Anschlussflachen durch die elektrisch isolierende Schicht elektrisch isoliert. Die ersten Öffnungen befinden sich an Kreuzungspunkten des Leiterbahngitters und sind an diesen Kreuzungspunkten unterbrochen. Die elektrisch leitende Schicht weist ein regelmässiges Raster von zweiten Öffnungen auf, welche die ersten Öffnungen umfassen und grösser sind als diese.

Mit dem Begriff "Leiterbahnen" ist hier mindestens eine durch Strukturierung in einzelne Bahnen zerfallende Leiterschicht gemeint, also eine Mehrzahl von in oder auf einem elektrischen Verbindungselement fest vorhandenen, im Allgemeinen flächigen Leitern. Dies im Unterschied zu nachträglich angebrachten, von der Unterlage abstehenden Leitern wie Bonds, Drahtverbindungen etc. Die Leiterbahnen haben den Vorteil der heute schon längst standardisierten und darum kostengünstigen Herstellung; ausserdem erlauben sie gemäss bevorzugten Ausführungsformen, einen Leuchtkörper direkt mit Anbringen auf der Leiterbahn zu kontaktieren - eine bedeutende Herstellungsvereinfachung.

Das Leuchtpaneel besitzt also quasi eine Trägerplatte, welche ein elektrisches Verbindungselement (nämlich eine Leiterplatte) bildet oder aufweist und darauf angebrachte Leuchtkörper sowie allenfalls noch weiteren Einheiten.

Eine bevorzugte Ausführungsform des Leuchtpaneels ist so ausgebildet, dass die - beispielsweise zwei Elektroden aufweisenden - Leuchtkörper direkt auf der Unterlage oder einer Leiterbahn befestigt und durch diese über eine der Elektroden kontaktiert sind. Für Leuchtkörper mit einem elektrischen Kontakt auf der Bodenfläche und einem zweiten elektrischen Kontakt auf der .Deckfläche ist vorgesehen, einen ersten Leuchtkörper jeder Untereinheit mit einem elektrisch leitenden Kontaktmittel - bspw. einem Drahtbond - direkt auf der leitenden Unterlage zu befestigen und gleichzeitig zu kontaktieren. Als Kontaktmittel kann ein handelsüblicher elektrisch leitender Kleber (Kontaktkleber) oder Lötzinn verwendet werden. Weitere Leuchtkörper jeder Untereinheit sind bspw. auf einer Leiterbahn aufgebracht und durch diese kontaktiert.

Es gibt auch Leuchtkörper, deren zwei elektrische Kontakte sich auf ein und derselben Oberfläche - der Deckfläche - befinden. Dann ist der erste Leuchtkörper jeder Untereinheit mit einem nicht notwendigerweise elektrisch leitenden Kontaktmittel auf einer Leiterbahn aufgebracht, wobei der elektrische Kontakt zwischen der Unterlage und dem ersten elektrischen Kontakt des Leuchtkörpers mittels eines geeigneten elektrischen Verbindungselementes das von der Kontaktfläche des Leuchtkörpers durch eine Öffnung in der isolierenden Schicht führt, sichergestellt wird. Dafür sind teilweise Öffnungen in der isolierenden Schicht nötig Die isolierende Schicht wird beispielsweise aus zwei isolierenden Filmen gebildet, dann ist die teilweise Öffnung eine Öffnung mindestens in dem Film, welcher nicht an der Unterlage anliegt. Die jeweils zweite Elektrode jedes Leuchtkörpers kann durch einen Drahtbond mit einer weiteren Leiterbahn oder mit einer Kontaktfläche elektrisch verbunden sein. 'Bonding' ist ein standardisiertes, automatisierbares und ökonomisches Verfahren.

Alternativ zu Drahtbonds kann die elektrische Kontaktierung der Leuchtkörper-Elektroden durch in eine flexible transparente Schicht integrierte Leiterbahnen sichergestellt werden. Die hierfür notwendigen Leiterbahnen können beispielsweise aus einer elektrisch leitenden, transparenten Schicht bestehen, also beispielsweise aus einer sogenannten ITO-Schicht (In₂O₃-SnO₂). Sie können aber auch durch ein Gitter sehr dünner metallischer Leiterbahnen realisiert werden. Die lokalen Dimensionen entweder der transparenten Leiterbahnen oder des leitenden Gitters sind vorzugsweise so gewählt, dass - ohne Fehlkontaktierungen - kein spezieller Ausrichtaufwand notwendig wird.

Am Markt erhältliche geeignete Leuchtkörper sind ungehäuste Leuchtdioden. Diese werden in unterschiedlichen Ausführungen angeboten. Einerseits variiert beispielsweise ihre Grundfläche zwischen 250 x250 µm und 500 x 500 µm, anderseits sind die beiden Elektroden zur elektrischen Kontaktierung entweder beide auf der Deckfläche angeordnet oder eine Elektrode befindet sich auf der Deckfläche und die zweite Elektrode auf der Bodenfläche. Im Prinzip können beliebige Leuchtdioden verwendet werden. In vielen Fällen sind aber Leuchtdioden mit einem elektrisch leitenden Substrat - bspw. SiC - vorzuziehen, da dann eine direkte Kontaktierung einer Elektrode durch Aufbringen auf einer Kontaktfläche erfolgen kann (wie bereits angedeutet) und da die im aktiven Bereich entstehende Wärme durch elektrische Leiter effizienter nach unten geleitet wird.

Das erfindungsgemässe Paneel kann Leuchtdioden einer bestimmten Farbe oder einer bestimmten Farbzusammenstellung aufweisen. Es können aber auch blaues - oder auch violettes oder ultraviolettes - Licht emittierende LEDs, z. B. mit GaN oder InGaN-Schichten, verwendet werden, vorzugsweise in Verbindung mit Fluoreszenz-Mittel: Das von den Leuchtkörpern ausgesandte blaue oder ultraviolette Licht wird durch sekundär emittierenden Farbstoff mindestens teilweise in längerwelliges Licht umgewandelt. Das ursprüngliche blaue oder ultraviolette Licht überlagert sich mit dem längerwelligen Licht, wobei sich in der Summe weisses Licht ergibt. Ggf. in Kombination mit Farbfiltermitteln in einer hier noch zu beschreibenden Anordnung kann durch ein erfindungsgemässes Leuchtpaneel Weisslicht in einer bisher nicht übertroffenen Farbechtheit hergestellt werden. Denkbar ist auch die Verwendung von entsprechenden Laserdioden, die den Vorteil einer wesentlich höheren Lichtabgabe besitzen, die allerdings auf einen relativ engen Raumwinkel beschränkt ist. Zudem sind solche Laserdioden relativ teuer.

Das Leuchtpaneel ist vorzugsweise so ausgestaltet, dass die Dichte der Anordnung der Leuchtkörper beginnend von einem Maximum nach unten angepasst werden kann. Die maximale Dichte ist vom Abstand der Öffnungen in der isolierenden Schicht und der daraus resultierenden Länge der einzelnen diskreten Leiterbahnen zur elektrischen Kontaktierung der Leuchtkörper abhängig. Wird eine kleinere Dichte von Leuchtkörpern gewünscht, werden beispielsweise zwei zu diesem Zwecke in grösseren Abständen voneinander angeordneten Leuchtkörper miteinander elektrisch verbunden. Dies geschieht hier dadurch, dass die beiden Leuchtkörper je mit der ihnen am nächsten liegenden Leiterbahn elektrisch verbunden werden und zusätzlich alle auf der direkten Verbindungslinie zwischen diesen beiden Leuchtkörpern liegende diskrete Leiterbahnen durch zusätzliche Kontaktmittel miteinander elektrisch verbunden werden.

Des Weiteren ist das Leuchtpaneel so gestaltet, dass die elektrisch seriell miteinander verbundenen Untergruppen von Leuchtkörpern durch zusätzliche elektrische Komponenten, wie zum Beispiel Widerstände, ergänzt werden können. Diese können auf den für die Leuchtkörper vorgesehen Leiterbahnen oder unmittelbar neben diesen angeordnet werden. So kann eine Spannungsanpassung für eine gesamte Untereinheit dadurch realisiert werden, dass zusätzlich ein geeigneter Widerstand seriell zu den Leuchtkörpern der Untereinheit geschaltet wird. Für einen einzelnen oder eine Gruppe von Leuchtkörpern kann eine Stromanpassung realisiert werden, indem ein geeigneter Widerstand parallel geschaltet wird.

Je nach Ausgestaltung einer Unterlage kann ein erfindungsgemässes Leuchtpaneel zur zusätzlichen Stabilisierung auf einem mechanischen Träger, beispielsweise einer Platte, angebracht werden.

Die Unterlage kann als im Wesentlichen metallische Platte mit bspw. kugelkalotten-oder paraboloidförmigen, eine flache Zone aufweisenden Vertiefungen versehen sein. Auf den flachen Zonen in den Vertiefungen können dann die Leuchtkörper angebracht sein. Diese Anordnung hat die Vorteile, dass sie einer dünnen Unterlage mechanische Stabilität verleihen, insbesondere den Auflageflächen für die Leuchtkörper.

Ausserdem besitzt das Paneel je nach dem noch Zusatzschichten, durch welche das von den Leuchtkörpern emittierte Licht geleitet wird.

Gemäss einer Ausführungsform ist eine Zusatzschicht eine transparente Schutzschicht. Diese schützt die leitenden und isolierenden Schichten sowie die Leuchtkörper und die elektrischen Verbindungen vor äusseren Einflüssen, wie beispielsweise mechanischen und chemischen Einwirkungen. Sie kann auch zur Ausrichtung des emittierten Lichts dienen.

Ein Beispiel für eine Zusatzschicht, die gleichzeitig für eine homogene Lichtverteilung sorgt, ist eine weichelastische Silikonschicht, mit integrierten kleinen, Licht reflektierenden Partikeln. Ein Leuchtpaneel besitzt dann beispielsweise eine geeignete Mischung von LEDs, die in den Farben Blau, Grün und Rot mit geeigneten Mischverhältnissen leuchten. Darüber ist dann eine homogenisierenden Schicht an- bzw. aufgebrachten, die dafür sorgt, dass das Paneel weisses Licht emittiert.

Ein anderes Beispiel für eine transparente Zusatzschicht ist eine mit sehr hohem optischem Brechungsindex, also beispielsweise Titandioxid oder ITO (In₂O₃-SnO₂), die einen Brechungsindex in der Grössenordnung 2.2 aufweisen. Wenn diese Schicht ca. die Dicke einer halben LED-Chip Breite aufweist und so strukturiert ist, dass sie Licht auch seitlich auskoppeln kann, ist dies eine Möglichkeit, die gesamthaft aus einem LED-Chip ausgekoppelte Lichtmenge deutlich zu steigern. Zusätzlich kann - wie weiter oben erwähnt - beispielsweise eine entsprechend strukturierte ITO-Schicht direkt zur elektrischen Kontaktierung der LED-Chips dienen.

Einen speziellen Vorteil hat eine weitere optionale Zusatzschicht. Diese Zusatzschicht weist Farbstoffe auf, welche die Wellenlänge des von den LEDs emittierten Lichts verändern (Bei einer solchen Schicht handelt es sich i.A. um eine fluoreszierende Schicht, also um eine Schicht mit einem sekundär emittierendem Farbstoff. In einer solchen Schicht wird die Wellenlänge 'verändert', indem das Primärlicht absorbiert und durch die Schicht nach dem Absorptionsprozess Sekundärlicht einer anderen, grösseren Wellenlänge abgegeben). Diese mit Farbstoffen versehene Zusatzschicht dient bspw. zur Umwandlung von kurzwelligem Primärlich in Weisslicht. Besonders warmes Licht entsteht, wenn nebst einer Mehrzahl von Blaulicht oder Violettlicht erzeugenden LEDs noch einige Rotlicht-und/oder Gelblichtdioden verwendet werden. Im Gegensatz zu gehäusten LEDs gemäss dem Stand der Technik dient die im Wesentlichen flache, mehrere LEDs überdeckende Schicht der Farbumwandlung des Lichtes einer Vielzahl von darunter liegenden Elektroden. Damit werden Randeffekte, beispielsweise Ringe, vermieden, wie sie von gehäusten Elektroden her bekannt sind. Nebenbei bemerkt könnte eine solche Schicht auch für andere Arrays von LEDs verwendet werden als dem erfindungsgemässen konfektionierbaren LED-Paneel.

Die im Wesentlichen flache Schicht, in welche der Farbstoff oder die Farbstoffmischung eingebracht ist, beispielsweise aus Silikon oder PMMA, dient je nach dem gleichzeitig als Schutzschicht über den LEDs bzw. dem gesamten Paneel.

Eine weitere optionale Zusatzschicht, welche mit der Schutzschicht identisch sein kann, ist im Wesentlichen transparent und dient dazu, eine homogene Lichtverteilung zu erzeugen und mögliche Wärmespannungen abzubauen.

Die Funktionen der obigen transparenten Schichten können auch durch eine einzige Schicht oder durch beliebige Kombinationen von Schichten erfüllt werden.

Die Zusatzschicht kann als von den Leuchtkörpern mechanisch entkoppelte, bspw. über Abstandhalter auf der Trägerplatte (=Unterlage mit Leiterstrukturen und allenfalls mechanischem Träger) fixierte, bspw. steife Abdeckschicht ausgebildet sein. Besonders vorteilhaft ist dies in Kombination mit einer mit dem erwähnten Vertiefungen für die Leuchtkörper versehenen Unterlage. Wenn die Leuchtkörper in Vertiefungen eingebracht sind, kann die Abdeckschicht relativ nahe an der Unterlage angebracht sein, ohne dass Bondverbindungen zwischen Leuchtkörpern und Leiterbahnen beeinträchtigt wären und ohne dass Scherspannungen auf die Leuchtkörper einwirken könnten.

In einer bevorzugten Ausführungsform ist die Unterlage so ausgestaltet, dass sie zur Wärmeableitung dient. Sie besteht dazu im wesentlichen aus elektrisch und wärmeleitenden Materialien und weist zusätzliche, zur Kühlung dienende Strukturen, beispielsweise Kühlrippen, auf.

Die Unterlage und eventuell auch die eine oder mehrere Zusatzschichten sind vorzugsweise so ausgebildet, dass sie Solltrennstellen aufweisen. Solltrennstellen sind lokale Strukturen, die anzeigen, wo das Leuchtpaneel in kleinere funktionsfähige Teilstücke unterteilt werden kann und vorzugsweise eine solche Zerteilung gleichzeitig erleichtern. Beispiele für Solltrennstellen sind Reihen von fehlenden Kühlrippen oder lokale Ausdünnungen von Schichten. Das Leuchtpaneel kann entlang solcher Solltrennstellen bis auf kleinste funktionsfähige Untereinheiten oder Gruppen von kleinsten funktionsfähigen Untereinheiten zerteilt werden.

Die Grösse einer kleinsten Untereinheit kann unterschiedlich sein und beinhaltet typischerweise zwei, drei, vier, fünf oder sechs LEDs. Ein Paneel kann Untereinheiten verschiedener Grössen aufweisen. Dies ist aufgrund der erfindungsgemässen Ausgestaltung des Paneels ohne Weiteres und ohne grossen Konstruktionsaufwand möglich. Eine Anlage zur automatisierten Herstellung des Paneels muss einfach so programmiert werden, dass die LEDs und die Bonds, oder allenfalls zusätzlich elektrische Bauelemente wie beispielsweise Widerstände, an den entsprechenden Stellen angebracht werden. Wenn man zusätzlich noch in Betracht zieht, dass verschiedenfarbige LEDs beliebig plaziert werden können, sieht man, dass der Flexibilität und den Gestaltungsmöglichkeiten praktisch keine Grenzen gesetzt sind.

Leitende und isolierende Schichten und Leiterbahnen werden beispielsweise mit an sich bekannten Verfahren aus der Leiterplattentechnik aufgebracht. Diese beinhalten bspw. das Fotostrukturieren von Leiterbahnen sowie das Auflaminieren von Kunststoff-schichten oder das aufsputtern von anderen elektrisch isolierenden Schichten. Die Leiterbahnen können aber selbstverständlich auch mit neueren Leiterplatten-technologien gefertigt sein, bspw. mit einem neu entwickelten Prägeverfahren. Auch das Aufbringen von Zusatzschichten erfolgt in an sich bekannter Art. Dadurch wird der Herstellungsprozess der Leuchtpaneels wesentlich vereinfacht, da er automatisiert werden kann, und die erfindungsgemässen Leuchtpaneels als vorgefertigte Serienwaren erhältlich sind. Die Herstellungskosten für einzelne Paneels können damit äusserst gering gehalten werden. Ein weiterer Vorteil ist, dass sämtliche Strukturen sehr dünn gestaltet werden können und somit einen äusserst geringen Wärmeleitwiderstand aufweisen. Dies erlaubt eine effektive Wärmeabfuhr aus dem Bereich der LEDs. Zusammen mit den optional vorhandenen Kühlstrukturen wird dadurch eine dichtere Anordnung von LEDs ermöglicht. Dadurch wiederum wird die Flexibilität bei der Nutzung des Paneels noch weiter erhöht.

Das gruppenweise serielle Verschalten von LEDs erlaubt zudem die Verwendung von handelsüblichen Spannungsversorgungen, wie Transformatoren, die typischerweise mit Spannungen von 12V bzw. 24V arbeiten. Handelsübliche LEDs können typischerweise mit lediglich 2V oder 4V betrieben werden. Eine serielle Schaltung von beispielsweise 6x2V, 3x4V, 4x2V+1x4V, usw., erlaubt es, die Versorgungsspannung des gesamte Leuchtpaneels oder von Teilstücken davon deutlich höher anzusetzen, als es für einzelne LEDs möglich wäre. Durch die serielle und/oder parallele Zuschaltung zusätzlicher elektrischer Widerstände zu einer kleinsten funktionsfähigen Untereinheit oder zu einzelnen Leuchtkörper-Untergruppen sind den Möglichkeiten zur Spannungs-, beziehungsweise Stromanpassung, fast keine Grenzen gesetzt. Sind kleinste funktionsfähige Untereinheiten zusätzlich über eine Unterlage parallel miteinander verbunden, so leuchtet ein Leuchtpaneel oder ein Teilstück davon, sobald die zwei Verbindungen einer LED mit der erforderlichen Spannungsdifferenz versorgt werden.

Die Verwendung von höherer Spannung hat nicht nur Vorteile bezüglich der Auswahl von Spannungsquellen, sondern reduziert auch die fliessenden Ströme. Diese Reduktion erlaubt eine Verkleinerung der Leiterquerschnitte und verkleinert die Wärmeerzeugung. Die elektrische Versorgungsspannung kann wahlweise als Gleichspannung oder als Wechselspannung gewählt werden. Bei der Verwendung von Wechselspannung muss allerdings ein reduzierter Wirkungsgrad in Kauf genommen werden.

Im Folgenden wird das erfindungsgemässe Leuchtpaneel anhand beispielhafter Ausführungsformen erläutert.
Fig. 1 zeigt eine schematische Schrägsicht auf Schichten eines ersten Beispiels eines erfindungsgemässen konfektionierbaren Leuchtpaneels.
Fig. 2 zeigt eine geschnittene Schrägsicht auf einen Aufbau eines zweiten Beispiels eines erfindungsgemässen Leuchtpaneels.
Fig. 3 zeigt eine Ausführungsform des erfindungsgemässen Leuchtpaneels mit hohlspiegelförmigen Strukturen.
Fig. 4 zeigt eine weitere Ausführungsform des erfindungsgemässen Leuchtpaneels mit 'globe tops',
Fig. 5 zeigt eine schematische Schrägansicht einer weiteren Ausführungsform des erfindungsgemässen Leuchtpaneels,
und Figuren 6a und 6b zeigen weitere Ausgestaltungen von erfindungsgemässen Leuchtpaneels.

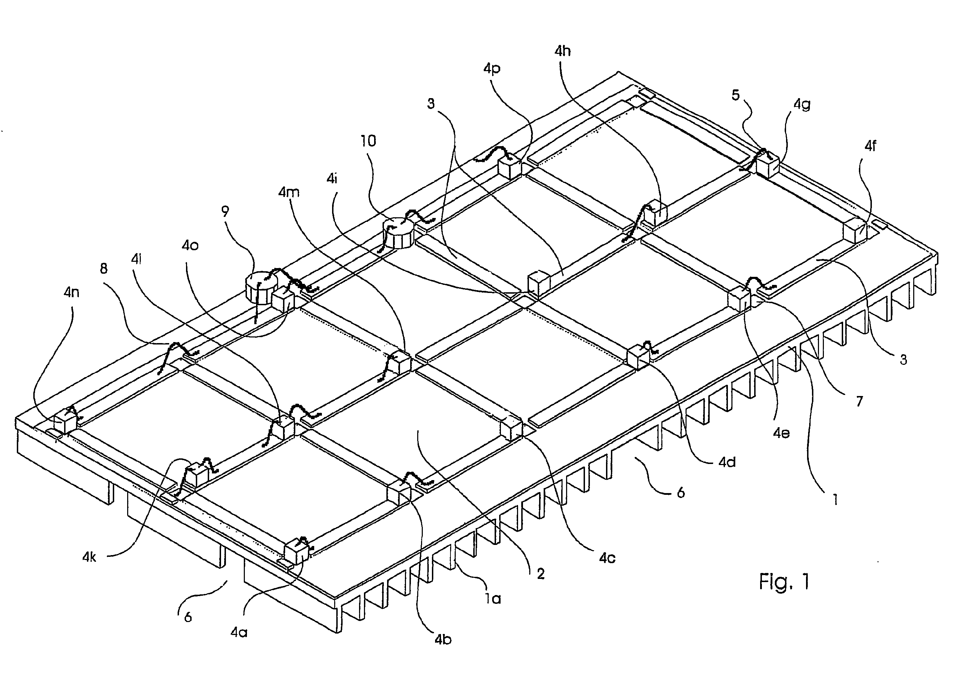

In **Figur 1** ist eine elektrisch leitende Unterlage 1 gezeigt. Sie ist im gezeichneten Beispiel als mit Kühlrippen 1a versehene Aluminium- Grundplatte ausgestaltet. Die Unterlage kann auch mehrteilig aufgebaut sein. Wenn aufgrund der LED-Dichte die Kühlung kein Thema ist, kann sie beispielsweise als mit einem Metallfilm überzogene Kunststoffplatte ausgebildet sein. Wenn mechanische Festigkeit nicht nötig oder nicht erwünscht ist, kann sie auch durch eine leitende Folie gebildet werden. Diese kann dann auf einem beliebigen Gegenstand aufgebracht werden.

Auf der Unterlage 1 ist ein mit lokalen Öffnungen 7 versehener, erster isolierender Film 2 aufgebracht. Der Film besteht beispielsweise im Wesentlichen aus SiN, SiC, oder in der Leiterplattentechnik gängigen Polymeren. Er besitzt bspw. eine Dicke von 0.5-50 µm. Auf dem ersten Film 2 befindet sich eine regelmässige, gitterförmige Anordnung von Leiterbahnen 3, beispielsweise aus Kupfer. Die Leiterbahnen 3 sind durch den ersten isolierenden Film 2 elektrisch von der Unterlage 1 getrennt.

In der Figur sind vier Untereinheiten von Leuchtdiodenchips (LED-Chips oder kurz LEDs) 4a, 4b, 4c, 4d, 4e, 4f, 4g, 4h, 4i, 4k, 41, 4m, 4n, 4o, 4p gezeigt, welche auf der Unterlage 1 und den Leiterbahnen 3 verteilt angebracht und mit leitfähigem Kontaktkleber befestigt sind. Sie sind bis auf drei LEDs 4k, 41, 4m, basisseitig durch die Unterlage 1 oder eine Leiterbahn 3 kontaktiert. Zwei erste der in der Figur links dargestellten Untereinheiten besitzen je drei in Serie geschaltete LEDs. Die rechts dargestellte dritte Untereinheit setzt sich aus sechs in Serie geschalteter LEDs 4d, 4e, 4f, 4g, 4h, 4i zusammen.

Drei Untereinheiten besitzen jeweils einen, direkt mit seiner ersten, auf der Unterseite des Chips angeordneten elektrischen Kontaktfläche auf der Unterlage 1 aufgebrachten, LED-Chip 4a, 4d, 4n, welche wir im Folgenden als die ersten LEDs jeder Untereinheit betrachten. Der erste LED-Chip 4k der zweiten Untereinheit (4k, 41, 4m), ist auf einer Leiterbahn 3 angeordnet und mittels eines Drahtbondes 5 von seiner ersten elektrischen Kontaktfläche her durch eine Öffnung 7 elektrisch mit der Unterlage 1 verbunden. Die ersten LEDs sind jeweils von ihrer zweiten, auf der Oberseite des Chips angeordneten elektrischen Kontaktfläche her durch einen Drahtbond 5 mit einer Leiterbahn 3 verbunden. Die in der Serienschaltung darauf folgenden weiteren LEDs 4b, 4c, 4e, 4f, 4g, 4h, 4i, 41, 4m, 4o, 4p sind jeweils auf einer Leiterbahn 3 angebracht, die durch Drahtbonds 5 mit der bzw. einer der Top-Elektrode des entsprechenden vorgeschalteten LED-Chips verbunden sind. Die Top-Elektrode jedes letzten LED-Chips 4c, 4i, 4m, 4p in der Serienschaltung ist durch einen Drahtbond 5 kontaktiert, welcher auf eine in der Figur der Übersicht halber nicht gezeichneten Deckschicht führt. In einer vierten Untereinheit sind die Leuchtdioden 4n, 4o, 4p mit verdoppelten Abständen angeordnet. Die dadurch vorhandenen elektrischen Unterbrüche zwischen den einzelnen Leiterbahnen 3 zur elektrisch seriellen Verbindung der LEDs 4n, 4o, 4p, sind in einem Fall durch einen zusätzlichen Drahtbond als Leiterbahn-Kontaktmittel 8 verbunden. Im zweiten Fall sind die Leiterbahnen 3 zum Zwecke der Spannungsanpassung der gesamten entsprechende Drahtbonds 5 zur elektrischen Kontaktierung desselben, überbrückt. Parallel zu einem der Leuchtdioden 40 ist ein weiterer Widerstand 9 angeordnet, der für diesen einen Leuchtdioden 40 eine Stromanpassung ergibt.

Die Unterlage 1 ist mit Solltrennstellen 6 versehen, entlang denen ein beispielsweise quadratmetergrosses LED Paneel in Teilstücke bis auf eine kleinste Untereinheit zerteilt werden kann. Die Solltrennstellen 6 können auch Einheiten umgeben, welche mehrere Untereinheiten umfassen. Der isolierende Film 2, die Leiterbahnen 3 und die Bonds 5 können mit in der Leiterplattenherstellung bekannten Mitteln und Techniken hergestellt sein.

Anhand der folgenden Figuren werden hauptsächlich Unterschiede der in den Figuren gezeigten Ausführungsformen zu den bereits beschriebenen Ausführungsformen erläutert, auf eine Beschreibung der gemeinsamen Merkmäle wird verzichtet.

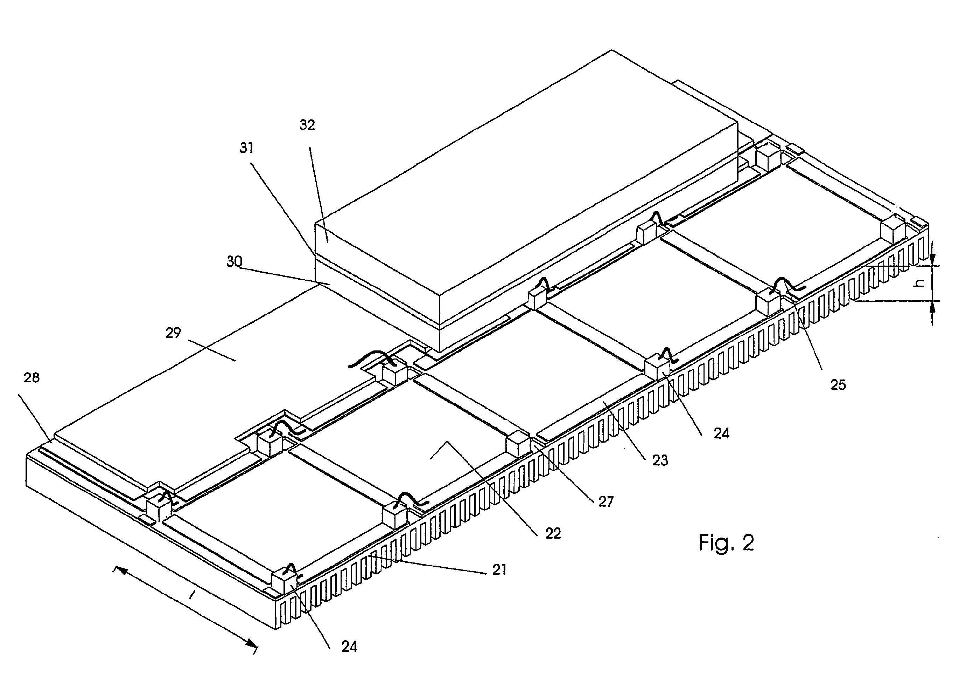

In **Figur 2** ist eine schematische Schrägansicht auf den Aufbau einer weiteren Ausführungsform des erfindungsgemässen Leuchtpaneels gezeigt. Die Schaltungsanordnung dieser Ausführungsform unterscheidet sich von derjenigen der Figur 1 dadurch, dass nur Untereinheiten mit jeweils drei in Serie geschalteter LEDs vorhanden sind. In dieser Figur ist auch die elektrisch leitende Deckschicht 29 teilweise dargestellt. Zusätzlich sind auf dieser liegende Zusatzschichten 30-32 zu sehen. Die elektrisch leitende Unterlage 21 dient zur Parallelkontaktierung seriell geschalteter LED-Chips 24. Zur Optimierung der Kühlung der LED-Chips 24 weist die Unterlage 21 Kühlrippen auf. Auf die Unterlage 21 aufgebracht ist der erste isolierende Film 22 mit einer regelmässigen Anordnung von Öffnungen 27. Durch diese Öffnungen 27 kann die Unterlage 21 durch die Isolationsschicht 22 hindurch elektrisch kontaktiert werden. Auf die erste Isolationsschicht 22 aufgebracht sind die diskreten Leiterbahnen 23, die zur seriellen Schaltung der LED-Chips 24 dienen. Über den Leiterbahnen 23 befindet sich ein zweiter elektrisch isolierender Film 28 mit Öffnungen. Der erste und der zweite isolierende Film bilden zusammen eine die Leiterbahnen im Wesentlichen einbettende isolierende Schicht. Je nach Herstellungsverfahren (Aufbringen der Schichten bei hohen oder niederen Temperaturen) und Schichtmaterialien ist die Schicht dabei bis auf die Leiterplatten homogen oder entlang einer zwischen den Filmen liegenden Trennebene strukturiert. Die leitende Deckschicht 29 ist ebenfalls lokal mit Öffnungen versehen und dient zusammen mit der Unterlage 21 zur Parallelkontaktierung der Untereinheiten. Die Deckschicht kann auch aus dünnen, die Top-Elektroden kontaktierenden elektrischen Leiterbahnen bestehen oder mit solchen Leiterbahnen verbunden sein.

Die Aussparungen in der Deckschicht 29 können so gestaltet sein, dass sie sowohl die LED-Chips 24 als auch kontaktierbare Flächen jeder benachbarten Leiterbahn umfassen. Damit kann auch die Deckschicht absolut standardisiert hergestellt sein, und beliebige Verschaltungen der LEDs ermöglichen.

Die leitende Schicht 29 kann spiegelnd gestaltet sein, um die Lichtausbeute der LEDs 24 zu verbessern.

Die Untereinheiten von in Serie geschalteten LEDs bzw. das Leuchtpaneel oder Teilstücke davon leuchten, sobald zwischen der Unterlage 21 und der Deckschicht 29, welche als Kontaktflächen fungieren, eine durch die LEDs und ihre Schaltungsanordnung bestimmte Gleichspannung angelegt wird.

Die Dicke h der Unterlage inklusive Kühlrippen, elektrisch isolierende Schicht und Deckschicht bewegt sich in einem Bereich zwischen ca. 0.5 mm und einigen mm, bspw. 3 mm. Wie bereits erwähnt kann die Unterlage auch anders, bspw. ohne Kühlrippen ausgestaltet sein. In diesem Fall ist die Unterlage natürlich entsprechend dünner. Die Werte für die Distanz 1 von LED zu LED beträgt vorzugsweise ca. 1.4 mm - 10 mm. Das ergibt ein Leuchtpaneel mit einer LED-Dichte von 1 - 49 LED/cm². Ein typischer Wert für 1 ist 2.5 mm, was ein Leuchtpaneel mit einer LED Dichte von 16 LED/cm² ergibt. Die LED-Dichte kann ohne weiteres verkleinert oder vergrössert werden, wobei beim momentan erhältlichen LEDs ein oberer Wert bei etwa 64 LED/cm² liegen dürfte.

Über der Verschaltungsanordnung der LED-Chips 24 sind drei Zusatzschichten 30-32 aufgebracht. Die erste, transparente Zusatzschicht 30 ist eine, weiche, elastische Deckschicht, z.B. im Wesentlichen aus Silikon bestehende Schicht, die mit kleinen reflektierenden Partikeln versetzt ist. Sie dient dazu, für eine homogene Lichtverteilung zu sorgen. Die erste Zusatzschicht 30 kann des weiteren dazu dienen, die LED-Chips 24 gefährdende Wärmespannungen abzubauen.

Die zweite Zusatzsschicht 31 ist im Wesentlichen mit sekundär emittierendem Farbstoff oder einer Farbstoffmischung versehen, beispielsweise mit Lumineszenzfarbstoff. Je nach Farbstoffmischung werden in diesem Beispiel die LEDs so ausgewählt, dass sie blaues Licht emittieren. Durch die zweite transparente Schicht wird von den LEDs ausgesandtes Licht zumindest teilweise in längerwelliges Licht umgewandelt. Das in der Summe ausgestrahlte Licht ist dann je nach Farbstoffmischung eine Überlagerung unterschiedlicher Wellenlängen. Je nach Farbe der LEDs und Menge und Beschaffenheit des Farbstoffs, kann ein erfindungsgemässes Leuchtpaneel oder Teilstücke davon in praktisch beliebiger Farbe leuchten. Zusätzlich führt die schichtartige Anordnung der Zusatzschichten zu einer homogenen Lichtverteilung ohne Randeffekte. Dies steht im Kontrast zu gehäusten LEDs gemäss dem Stand der Technik. Das Gehäuse von diesen kann mit einer Lumineszenzschicht versehen sein. Dies führt aber immer zu anisotropen Farbverteilungen, welche vom Betrachter als Ringe wahrgenommen werden.

Die dritte Zusatzschicht 32 ist transparent und dient als Schutzschicht. Sie besteht bspw. im Wesentlichen aus PMMA oder PET. Sie kann auch optische Elemente beinhalten kann, die das Licht wunschgemäss ausrichten. Die Schutzschicht 32 ist aus einem Material hergestellt, das eine gewisse UV-Beständigkeit aufweist.

Je nach Ausgestaltung des Paneels können die Funktionen der drei Zusatzschichten 30-32 auch mit einer einzigen, mit zwei oder mit vier oder mehr teilweise transparenten Schichten realisiert werden. Es versteht sich auch, dass die von den Zusatzschichten wahrgenommenen Funktionen für die Funktionsfähigkeit des Paneels nicht essentiell sind und somit die Zusatzschichten auch ganz oder teilweise weggelassen werden können.

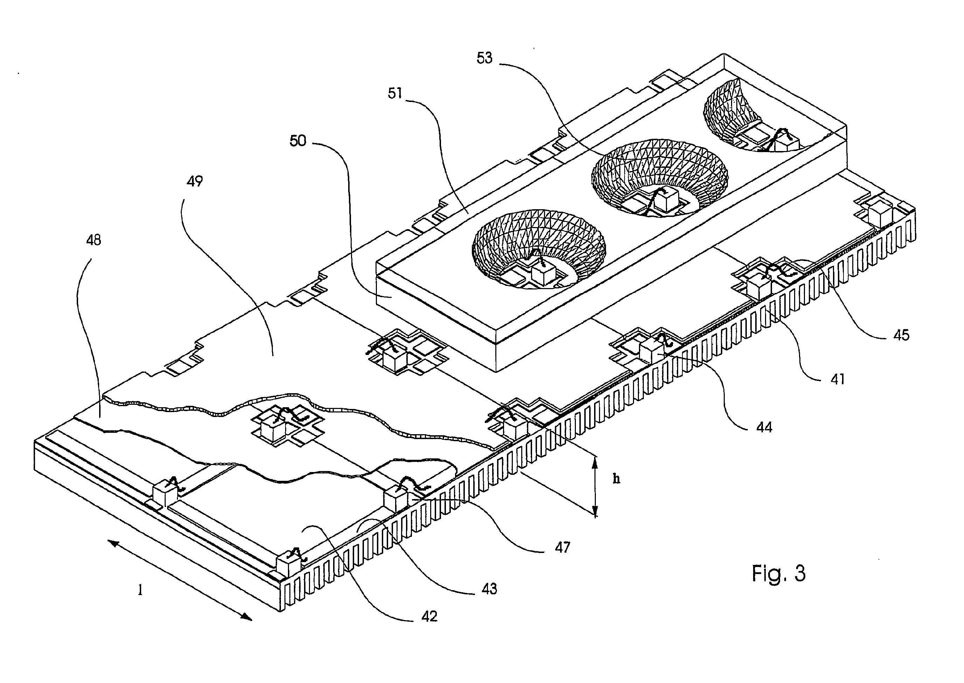

In Figur 3 ist eine weitere Ausführungsform des erfindungsgemässen Leuchtpaneels zu sehen. Das Paneel besitzt eine elektrisch leitende Unterlage 41, einen ersten und einen zweiten isolierenden Film 42, 48, diskrete Leiterbahnen 43 zur seriellen Schaltung der LED-Chips 44 und eine leitende Deckschicht 49, mit der die letzten LED-Chips einer Serie mittels Drahtbond 45 verbunden sind. Sämtliche Schichten weisen, wo nötig, Öffnungen 47 zur elektrischen Kontaktierung auf.

Zwei Zusatzschichten 50, 51 sind dergestalt ausgebildet, dass sie um LED-Chips herum halbschalenförmige Vertiefungen 53 aufweisen. Die halbschalenförmigen Vertiefungen sind vorzugsweise mit einer spiegelnden Schicht, z.B. Silber oder Aluminium, beschichtet, so dass die Vertiefungen wie Hohlspiegel wirken. Das von den LEDs emittierte Licht wird auf den Raumwinkel beschränkt, der vom Hohlspiegel vorgegeben ist. Die Vertiefungen 53 können mittels Prägung in die weichen transparenten Schichten 50, 51 hergestellt sein. Zum Schutz der LEDs und isolierender und leitender Schichten sowie von elektrischen Verbindungen und einer eventuellen Hohlspiegelbeschichtung, können die Vertiefungen mit einem transparenten Schutzmaterial, wie beispielsweise Silikon oder PMMA, aufgefüllt sein. Es ist auch möglich, die Vertiefungen nur in die erste Zusatzschicht 50, beispielsweise eine homogenisierende und/oder sekundär emittierenden Farbstoff enthaltende Schicht, einzubringen. Die erste Zusatzschicht kann im Übrigen auch gänzlich untransparent und nur mit reflektierenden Oberflächen versehen sein. Die transparente Schutzschicht 51 überzieht schützend das gesamte Paneel, insbesondere auch die LED-Chips und halbschalenförmigen Vertiefungen 53.

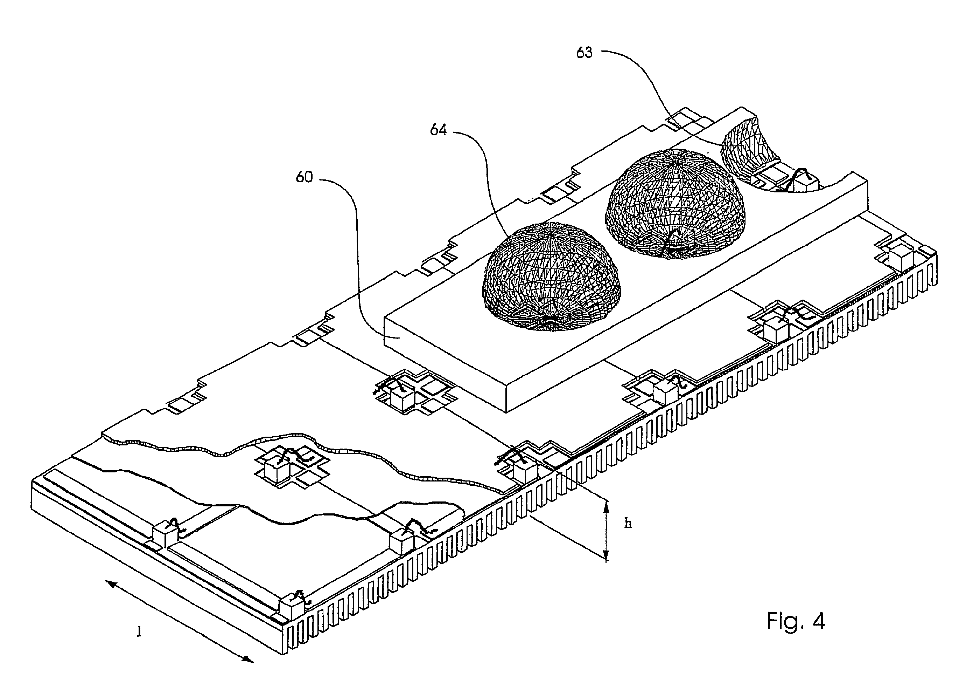

Eine weitere Ausführungsform des erfindungsgemässen konfektionierbaren Paneels ist in Figur 4 zu sehen. Die Unterlage und Schichtanordnung inklusive LED-Chip-Verschaltung, ist im wesentlichen gleich wie in Figur 3. Auch dieser Ausführungsform ist eine Zusatzschicht 60 mit halbschalenförmigen Vertiefungen 63 versehen. In diese Vertiefungen 63 ist ein transparentes Material, z. B. Silikon, so eingefüllt, dass es eine Kalotte bildet. In der Beleuchtungstechnik werden solche Kalotten 'globe tops' genannt. Diese halbschalenförmigen Ausbuchtungen 64 verteilen das von den LEDs emittierte und von Schutzschichten 60 eventuell modifizierte Licht homogen über den gesamte Halbraum nach aussen.

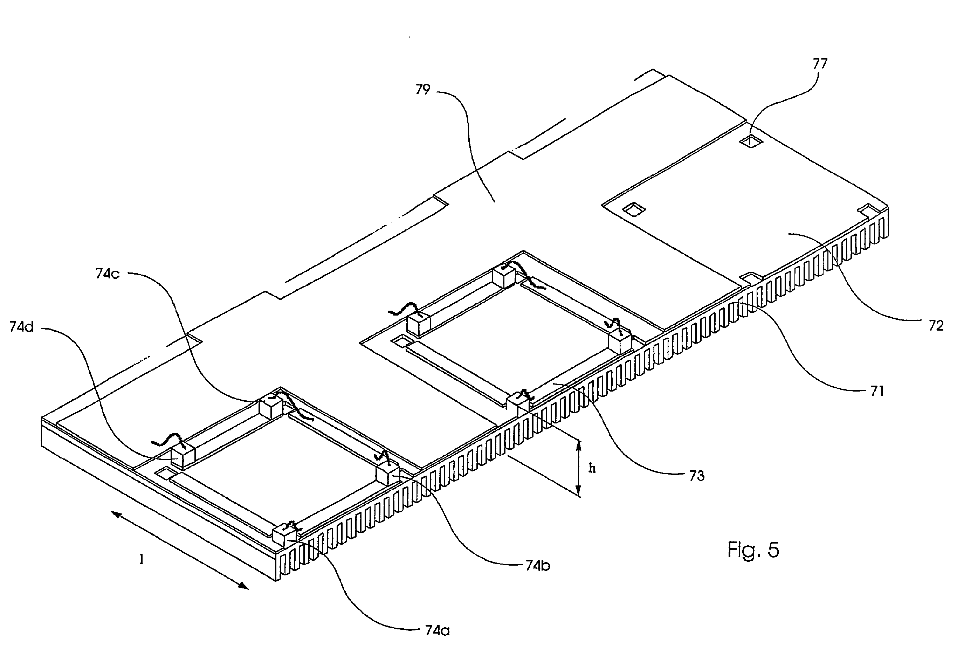

Das konfektionierbare, Licht emittierende Leuchtpaneel gemäss einer der Figuren 1 bis 4 wird unter Verwendung von ungehäusten Leuchtdioden zum Beispiel wie folgt hergestellt:
Auf einer Unterlage 1,21,41 wird ein erster elektrisch isolierender Film 2,22,42 mit einem regelmässigen Raster von ersten Aussparungen 7,27,47 aufgebracht.
Auf dem ersten elektrisch isolierenden Film werden Leiterbahnen 3,23,43 so aufgebracht, dass sie in einem regelmässigen Raster im Wesentlichen zwischen ersten Aussparungen verlaufen. Die Strukturierung des entsprechenden Leitermaterials erfolgt bspw. in an sich bekannter Art mittels Photostrukturierung.
Auf den ersten Film und die Leiterbahnen wird ein zweiter elektrisch isolierender Film 28, 48 aufgebracht, welcher zweite Aussparungen besitzt, die die ersten Aussparungen umfassen und grösser sind als diese, so dass zu jeder ersten Aussparungen benachbarte Leiterbahnen zum Teil freiliegen,
Der zweite elektrisch isolierende Film wird mindestens teilweise mit einer elektrisch leitenden Deckschicht 29, 49 bedeckt, wobei wieder bspw. auf konventionelle Art strukturiert wird.
LEDs 4a,4b,4c,4d,4e,4f,4g,4h,4i,4k,4l,4m,4n,4o,4p,24,44 werden so auf der entstandenen Platte aufgebracht, dass sie innerhalb der zweiten Aussparungen liegen und entweder von der Unterlage oder von den Leiterbahnen an einer ersten Elektrode kontaktiert werden.
Zweite Elektroden der LEDs und Leiterbahnen bzw. die Deckschicht 29, 49 werden elektrisch verbunden, wobei die LEDs so aufgebracht und die zweiten Elektroden der LEDs so mit Leiterbahnen und der Deckschicht verbunden, dass in Serie geschaltete funktionsfähige Untereinheiten von LEDs entstehen.
Anschliessend werden ggf. noch die Zusatzschichten 30,31,32,50,51,60 mit lichtverändernden und/oder ausrichtenden Eigenschaften und/oder als Schutzschichten angebracht.
Auch die in der Figur 5 dargestellte Ausführungsform besitzt eine elektrisch leitende Unterlage 71 mit (optionalen) Kühlrippen und eine darauf aufgebrachte elektrisch isolierende Schicht 72. Diese Ausführungsform hat aber die Besonderheit, dass die Deckschicht 79 und die Leiterbahnen 73 in Schichtaufbau in derselben Schicht angeordnet sind und im Herstellungsprozess aus derselben Schicht gefertigt wurden; die hier wesentliche elektrische Isolation der Leiterbahnen von der Deckschicht erfolgt also nicht mehr durch eine 'vertikale' Trennung der Leiterbahnen von der Deckschicht via einen elektrisch isolierenden Film, sondern durch die Laterale Trennung, wobei zwischen der Deckschicht und den Leiterbahnen Abschnitte der freiliegenden isolierenden Schicht 72 angeordnet sind. Zu diesem Zweck besitzt die Deckschicht grosse, hier im Wesentlichen quadratische (die Form ist nicht wesentlich und kann den Bedürfnissen entsprechen beliebig gewählt sein) Aussparungen, welche je eine ganze Untereinheit umfassen. Die ersten LEDs 74a der Untereinheiten sind in Aussparungen 77 in der isolierenden Schicht 72 direkt auf der Unterlage 71 aufgebracht und werden durch diese kontaktiert. Eine obere Elektrode der ersten LEDs ist mittels einem Drahtbond mit einer Leiterbahn verbunden. Die nächsten LEDs 74b der Untereinheit sind direkt auf der von der "Top"-Elektrode der ersten LED 74a her kontaktierten Leiterbahnen angeordnet. Die dritten, vierten, ... LEDs können analog auf jeweils nächsten, von der vorhergehenden LED her kontaktierten Leiterbahnen sitzen. Die in der Figur gezeichnete Anordnung ist jedoch abweichend davon gestaltet. Dort ist die dritte LED 74c umgekehrt gepolt (bzw. umgekehrt angebracht) auf derselben Leiterbahn angebracht wie die vierte Elektrode 74d; die "Top"-Elektrode dieser LED ist mit der von der zweiten LED durch einen Drahtbond kontaktierten Leiterbahn ebenfalls durch einen Drahtbond verbunden. Die zwischen der zweiten LED 74b und der dritten LED 74c liegende Leiterbahn dient also hier in erster Linie der Überbrückung der Distanz zwischen diesen zwei LEDs; sie ist trotzdem vorteilhaft genutzt, da ein von der zweiten zur dritten LED führender Drahtbond zu lang und zu anfällig wäre. Eine Elektrode der vierte LED 74d ist wie aus den vorhergehenden Ausführungsformen bekannt durch einen Drahtbond mit der Deckschicht 79 verbunden.
Die Deckschicht 79 muss nicht wie hier dargestellt bis auf die Aussparungen die bedecken isolierende Schicht bedecken, sondern kann ebenfalls durch diskrete Leiterbahnen ausgeformt sein.

Wie aus dieser Ausführungsform noch einmal ersichtlich ist, kann das erfindungsgemässe, einfache Prinzip mit von Elektrischen Anschlussflächen isolierten Leiterbahnen, durch welche die Leuchtkörper kontaktierbar sind, auf vielfache Weise genutzt werden. Die in den Ausführungsbeispielen gezeigten Schaltungsprinzipien sind eine reine Auswahl aus unbeschränkt vielen Möglichkeiten. Insbesondere kann von dem - an sich vorteilhaften - kontaktierenden Anbringen einer Elektrode der Leuchtdioden auf der Unterlage oder auf einer Leiterbahn abgewichen werden, und es können die Leiterbahnen als reine Mittel zur Distanzüberbrückung genutzt werden. Dies hat insbesondere auch bei LEDs auf einem elektrisch isolierenden Substrat seine Bedeutung, wo beide Elektroden auf einer oben liegenden Fläche liegen. In diesem Fall können alle LEDs direkt auf freigelegte Stellen in der Unterlage befestigt werden, und alle Kontaktierungen laufen über Drahtbonds.

Das Paneel der Figur 5 besitzt eine weitere Besonderheit: Die Untereinheiten sind dadurch, dass sie komplett innerhalb von Aussparungen in der Deckschicht liegen, optisch eindeutig sichtbar von den anderen Untereinheiten abgetrennt. Dies erleichtert dem Benutzer das Konfektionieren. Dafür können die Untereinheiten bei Vorliegen einer Leiterplatte als Grundbaustein für das Paneel weniger flexibel gestaltet werden, ausser man bedient sich der Mittel, welche anhand der nächsten Figur erklärt werden.

Wie schon aus den vorhergehenden Ausführungsbeispielen wird hier noch verstärkt sichtbar, dass die Deckschicht keineswegs eine bedeckende Schicht sein muss; mit Deckschicht ist vielmehr einfach die zweite, die Untereinheiten parallel kontaktierende elektrisch leitende Schicht gemeint.

Das Paneel der Figur 5 ist im Vergleich zu den vorstehend aufgeführten Paneelen eher einfacher in der Herstellung. Die elektrisch isolierende Schicht kann als eine einzige Schicht auf die Unterlage aufgebracht und mit einem regelmässigen Raster von Aussparungen versehen werden. Anschliessend wird eine leitende Schicht aufgebracht und so strukturiert, dass einerseits die hier flächige Deckschicht 79 mit Aussparungen und andererseits innerhalb der Aussparungen diskrete, als Leiterbahnen fungierende Leiterschicht-Abschnitte entstehen. Anschliessend werden die Leuchtkörper wie in den vorherigen Beispielen ausgeführt auf die Unterlage oder auf Leiterbahnen aufgesetzt.

Selbstverständlich kann auch das Paneel der Figur 5 mit Zusatzschichten wie vorstehend beschrieben versehen sein.

Das ganze Paneel kann - genau so wie alle anderen Paneele - einen "all non-organic"-Aufbau aufweisen. In diesem Fall ist die isolierende Schicht nicht wie an sich gängig und hier auch möglich eine Polymerschicht, sondern bspw. eine Metalloxid-Schicht. Im hier beschriebenen Beispiel mit einer Unterlage aus Aluminium bietet sich dafür Al-Oxid an.

Ein all non-organic-Aufbau hat den Vorteil, dass alle Materialien eine gute Beständigkeit auch bei Temperaturen von über 100°C aufweisen, das Paneel soll bspw. Temperaturen von mindestens 120°C, vielleicht sogar von über 150°C aushalten können, ohne beschädigt zu werden.

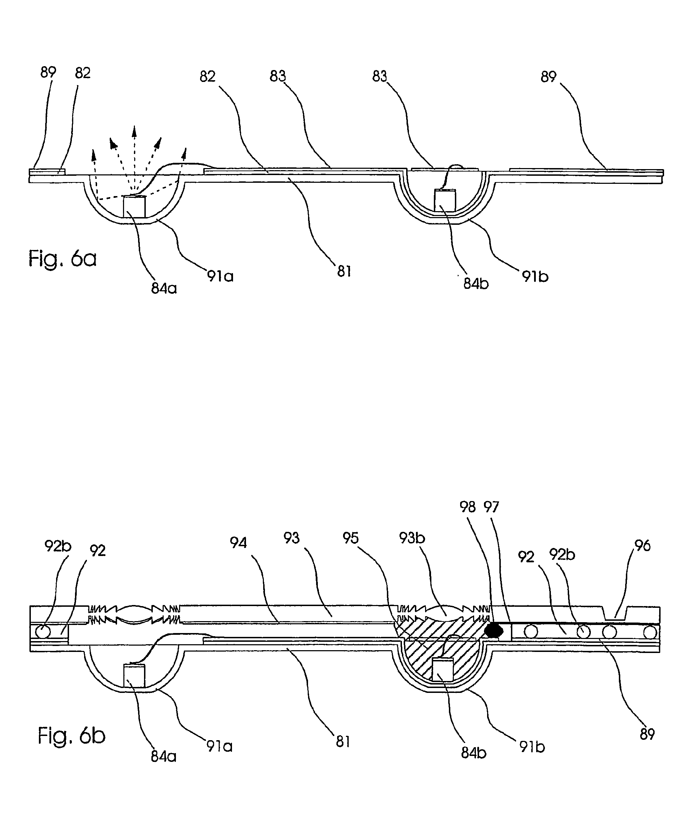

In den Figuren 6a und 6b ist eine weitere Ausführungsform dargestellt. Durch diese Ausführungsform werden weitere sich je nach Ausgangslage stellende Probleme gelöst. Die Leuchtkörper sind besser geschützt, und die optische Ausbeute kann verbessert sein. Aufgrund des Aufbaus gemäss den Figuren 6a und 6b kann auch die Zusatzschicht beliebig gewählt werden, es muss beispielsweise keine Rücksicht auf die Unterschiede in den Wärmeausdehnungskoeffizienten zwischen der Unterlage und der Zusatzschicht genommen werden. Der Schichtaufbau und die Verschaltung ist im gezeichneten Beispiel gemäss Figur 5 ausgebildet, er kann aber auch anders-bspw wie in den Figuren 1 bis 4 - gewählt werden.

Die Unterlage (Basisplatte) 81 ist metallisch und besteht, beispielsweise aus einem gut Wärme leitenden Material wie Aluminium, Kupfer etc. Sie wirkt wie anhand der vorstehenden Beispiele ausgeführt als erster paralleler Leiter und als Wärmesenke, selbstverständlich kann auch hier die Unterlage 81 noch Kühlrippen aufweisen. Die Unterlage 81 besitzte mehrere Vertiefungen 91a, 91b, die die Form einer teilweisen Kugelschale oder eines Ausschnitts aus einem Rotationsparaboloid haben. Wenn die innere Oberfläche der Vertiefungen reflektiert, dient die Vertiefung als Reflektorelement. Eine flache Zone an der Unterseite der Vertiefungen dient zum setzen eines LED-Chips. In Vertiefungen 91a ohne Isolationsschicht ist der jeweils erste LED-Chip 84a einer Untereinheit direkt auf die Unterlage aufgesetzt, in Analogie zu den vorstehend diskutierten Ausführungsbeispielen. Die weiteren LED-Chips 84b jeder Untereinheit befinden sich in Vertiefungen mit elektrischer Isolationsschicht 82 und mit einer darauf liegenden, auch als Reflektorschicht wirkenden, diskreten Leiterschicht 83 zur Kontaktierung der restlichen LED-Chips einer seriellen LED-Kette. Die Deckschicht 89 ist wie schon in Figur 5 mit den Leiterbahnen der diskreten Leiterschicht 83 im Schichtsystem in einer einzigen Schicht ausgebildet, was insbesondere für die Herstellung vorteilhaft ist, wie weiter unten ausgeführt werden wird.

Das Paneel der Figur 6b besitzt zusätzlich zu den Elementen des Paneels der Figur 6a eine modulare Zusatzschicht 93, welche als Abdeckschicht wirkt. Diese ist vorzugsweise so gewählt, dass sie im sichtbaren Bereich möglichst transparent ist und unter UV-Bestrahlung kaum trüb wird. Sie kann aus Kunststoff (bpw. Aus verdichtetem PET), aus Glas oder aus einem anderen transparenten Stoff bestehen.

Die Abdeckschicht 93 ist ein von der Trägerplatte separates, eigenes Element, d.h. sie ist nicht bspw. mit der Trägerplatte und den darauf liegenden Leuchtkörpern vergossen. Sie ist mechanisch entkoppelt von der Trägerplatte und den Leuchtkörpern in dem Sinn, dass laterale Verformungen oder eine unterschiedliche Wärmeausdehnung der Trägerplatte und der Abdeckplatte nicht zur Folge haben, dass Scherspannungen auf die Leuchtkörper wirken.

Die Abdeckschicht 93 kann mit optischen Elementen 93b zur Beeinflussung des von den LEDs erzeugten Lichts versehen sein. Im Bild sind diese optischen Elemente 93b Fresnel-Linsen. Sie können aber auch reflektierende (bspw. verspiegelte) Flächen aufweisen, möglicherweise als Ausschnitte eines Parabolspiegels oder Kugelspiegels, die Fresnel-Linsen-artig in kleine Abschnitte unterteilt sind. Die Abschnitte können wie bei einer Fresnel-Linse im Wesentlichen entlang einer Ebene - der Zusatzschicht-Ebene angeordnet sein. Damit kann die in einem bestimmten, gewünschten Winkel abgestrahlte Lichtleistung im Verhältnis zur abgestrahlten Primär-Lichtleistung (also ein Wirkungsgrad) durch eine Richtwirkung erhöht werden. Durch die hervorragende Bündelung kann der Wirkungsgrad nahe demjenigen von T1 ¾-Gehäusen liegen. An der Innenseite der Zusatzschicht 93 kann ein optisch wirksames Schichtsystem 94 - eventuell bestehend aus einer einzigen Schicht für die ganze oder teilweise Wandlung von blauem, violettem oder ultraviolettem Licht in längerwelliges Licht aufgetragen sein. Zusätzlich kann - beispielsweise durch eine separate Schicht im Schichtsystem 94 - vorgesehen sein, dass allenfalls übermässig vorhandene blaue Lichtanteile herausgefiltert werden. Die sekundär emittierenden Farbstoffe (Phosphore) oder auch filternde Stoffen können auch als feine Partikel in der Abdeckschicht vorhanden sein.

Die Abdeckschicht ist mit einer Klebstoffschicht 92 auf der Trägerplatte (d.h. der Unterlage 91 mit darauf liegenden elektrisch leitenden und elektrisch isolierenden Schichten) aufgebracht. Zur exakten vertikalen Positionierung der Abdeckschicht kann diese mit Abstandkugeln 92b versetzt sein; Klebstoffschichten mit integrierten Abstandkugeln sind heute kommerziell als Folie erhältlich, bspw. von der Firma 3M). Die Dicke der Klebstoffschicht 92 bzw. der Durchmesser der Abstandkugeln 92b ist so gewählt, dass die Drahtbonds von der Abdeckschicht 93 nicht berührt werden, bspw. mindestens 50 µm. Die Klebstoffschicht 92 ist so strukturiert, dass sie mindestens die reflektierenden Zonen der Vertiefungen 91a, 91b ausspart.

In der Figur ist noch eine Hinterfüllung 95 der optisch wirksamen Zone mit einem transparenten Material gezeichnet. Eine solche Hinterfüllung kann verwendet werden, um eine verbesserte Auskopplung aus dem LED-Chip und einer verbesserte Einkopplung in die transparente Abdeckschicht 93 sicherzustellen; mit Vorteil hat sie dazu einen hohen Brechungsindex, beispielsweise einen höheren Brechungsindex als die Abdeckschicht 93. Zusätzlich ergibt diese Hinterfüllung eine Verbesserung des mechanischen und chemischen Schutzes des LED-Chips und der elektrischen Verbindungen (Drahtbonds). Je nach gewählter Geometrie kann sie dauerelastisch sein, um vollständig zu verhindern, dass Scherspannungen auf die LEDs einwirken können (wobei nur schon durch die gewählte Geometrie die in den Vertiefungen 91a, 91b liegenden LEDs weit gehend von Scherspannungen geschützt sind, auch wenn das Material der Hinterfüllung 95 nicht elastisch ist).

In der Figur ist auch dargestellt, wie allenfalls vorhandene Strukturierungen 96 der Abdeckschicht 93 vorhanden sein können. Diese Strukturierungen dienen bspw. als Sollbruchstellen bzw. Soll-Schnittlinien und auch als Entkopplungsstellen für mechanische Spannungen.

Ebenfalls ein optionales Element des Paneels der Figur 6b sind die zusätzlichen, lokal vorhandenen, transparenten oder undurchsichtigen elektrischen Leiterbahnen 97, welche an der Unterseite der Abdeckschicht 93 verlaufen und welche ermöglichen, dass eine serielle Kette von LEDs auch über die Deckschicht 89 als zweite parallele Leiterschicht hinweg weitergeführt werden kann. In der Anordnung gemäss Figur 5 verlaufen diese zusätzlichen Leiterbahnen zwischen einzelnen, in Aussparungen der Deckschicht 79 vorhandenen Untereinheiten. Das Bezugszeichen 98 bezeichnet die elektrische Verbindung einer unteren Leiterbahn 83 mit einer zusätzlichen Leiterbahn 97, zum Beispiel mit Leitklebstoff.

Die Abdeckschicht kann auch aus mehreren Teilschichten aus identischen oder verschiedenen Materialien zusammengesetzt sein (nicht gezeichnet). Bspw. kann im Spalt zwischen zwei Teilschichten ein Film mit den sekundär emittierenden Farbstoffen vorhanden sein. Die Abdeckschicht kann selbstverständlich auch direkt die sekundär emittierenden Farbstoffe enthalten, wobei diese Variante insbesondere für Abdeckschichten aus Kunststoff geeignet ist.

Die Vorteile Form der Trägerplatte mit Vertiefungen sind folgende: Durch die Vertiefungen wird die Steifigkeit bei bestehender Dicke erhöht. Die Vertiefungen erhöhen als mindestens annähernde Parabolspiegel die Lichtausbeute. Die Abdeckplatte kann als ebenes, von der Trägerplatte entkoppeltes Element vorhanden sein, welches zusätzliche Aufgaben (Fokussierung Filterung etc.) wahrnimmt (modularer Aufbau). Durch die mechanische Entkopplung wird verhindert, dass die LEDs von Scherspannungen betroffen sind, welche aufgrund von Wärmeausdehnungen vorhanden sein können. Die Abdeckplatte, wenn sie von der Trägerplatte getrennt ist, erlaubt, dass auf der Innenseite zusätzliche Schichten vorhanden sein können, welche keinem mechanischen Abrieb ausgesetzt sind und daher auch nicht abriebfest sein müssen. Und schliesslich wird durch die Formung der Vertiefungen auch die Oberfläche vergrössert, was eine bessere Wärmeableitung mit sich bringt.

Wenn das Paneel der Figur 6b in einem all-non-organic-Aufbau gefertigt wird, wird die Klebstoffschicht 92 mit Abstandskugeln 92b durch eine Metallfolie oder Glasfolie ersetzt, welche auf der Ober- und auf der Unterseite verlötet ist (bspw. mit Lötzinn oder mit Glaslot) oder welche mit einer Bondverbindung befestigt ist.

Im Prinzip kann aber eine Trägerplatte mit einer davon entkoppelten Abdeckschicht auch ohne die Vertiefungen ausgeformt sein. In diesem Fall muss aber der durch Abstandhalter gesichterte Abstand dieser beiden Elemente deutlich grösser sein als die Summe der Dicke des Leuchtkörpers und der Höhe des davon weggehenden Drahtbondes, gegenwärtig also deutlich grösser als ca. 250 µm + 200 µm. Dies ist für einige Anwendungen zu viel.

Die Herstellung einer Trägerplatte eines Paneels gemäss einer der Figuren 6a und 6b kann analog zu den Trägerplatten gemäss den Figuren 1 bis 5 geschehen, wobei zusätzlich noch die Vertiefungen beizubringen sind. Dazu wird bspw. eine Matrix von Stahlkugeln angelegt. Die Stahlkugeln werden so abgeschliffen, dass eine flache Zone entsteht. Die dann entstehende Tiefzieh- bzw. Prägeform wird dann zur Verformung der Unterlage verwendet. Die Verformung kann an der Unterlage im Rohzustand oder aufgrund der Duktilität der verwendbaren Materialien ohne weiteres auch an der bereits beschichteten Unterlage vorgenommen werden. Eine noch gezieltere Fokussierung des durch die LEDs erzeugten Lichts kann erwirkt werden, indem die Tiefziehform zur Beibringung der Vertiefungen nicht kugelkalottenförmige, sondern bspw. parabolische Erhebungen besitzt.

Die Deckschicht 29, 49 muss nicht bis auf Aussparungen das ganze Paneel bedecken. Sie kann auch nur teilweise bedeckend sein oder gar nur aus einem System von Leiterbahnen bestehen. Ausserdem kann sie unterbrochen sein, bspw. an den Solltrennstellen.

## Patentansprüche

1. Leiterplatte, zum Gebrauch als Baustein eines Leuchtpaneels, aufweisend
eine Unterlage (1,21,41,71,81) mit einer elektrisch leitfähigen Oberfläche,
und eine darauf aufgebrachte ersten elektrisch isolierende Schicht (2,22,42, 72,82) mit einem regelmässigen Raster von ersten Öffnungen (7,27,47,77),
regelmässig gitterartig angeordnete Leiterbahnen (3,23,43,73,83), welche von der Unterlage durch die erste elektrisch isolierende Schicht elektrisch isoliert sind,
wobei die ersten Öffnungen an Kreuzungspunkten des Leiterbahngitters angeordnet sind und die Leiterbahnen an diesen Kreuzungspunkten unterbrochen sind,
sowie mit einer von der Unterlage und von den Leiterbahnen elektrisch isolierten elektrisch leitenden Schicht (29,49,79,89) mit einem regelmässigen Raster von zweiten Öffnungen, welche die ersten Öffnungen umfassen und grösser sind als diese.

2. Lichtemittierendes Leuchtpaneel
mit einer Leiterplatte nach Anspruch 1,
sowie mit kleinsten Untereinheiten mit je mindestens zwei seriell geschalteten, durch Elektrizität betreibbaren, auf der Leiterplatte angebrachten
Leuchtdiodenchips (4, 24, 44, 74, 84), wobei die Leuchtdiodenchips der kleinsten Untereinheiten durch die Leiterbahnen (3, 23, 43, 73, 83) seriell elektrisch verbunden sind,
wobei die kleinsten Untereinheiten untereinander elektrisch parallel geschaltet sind, so dass Teilstücke des Leuchtpaneels, die je eine oder mehrere der kleinsten Untereinheiten umfassen, für sich funktionsfähige, abtrennbare Leuchtpaneele bilden,
und wobei die Unterlage (1, 21, 41, 71, 81) und die elektrisch leitende Schicht (29, 49, 79, 89) als Anschlussflächen zum elektrisch parallelen Kontaktieren der Untereinheiten fungieren.

3. Leuchtpaneel nach Anspruch 2, **dadurch gekennzeichnet, dass** mindestens einige der Leuchdiodenchips (4, 24, 44, 74, 84) direkt auf einer der Leiterbahnen (3, 23, 43, 73, 83) liegen und durch diese kontaktiert werden.

4. Leuchtpaneel nach Anspruch 2 oder 3 **dadurch gekennzeichnet, dass** jeder Leuchtdiodenchip eine erste und eine zweite Elektrode besitzt, dass die ersten Elektroden jedes ersten Leuchtdiodenchips (4a,4d,4k,4n,74a,84a) in jeder Untereinheit durch die Unterlage (1, 21, 41, 71, 81) elektrisch kontaktiert sind, dass die zweite Elektrode jedes letzten Leuchtdiodenchips (4c,4i,4m,4p,74d) jeder Untereinheit durch ein Kontaktmittel (5,25,45) mit der elektrisch leitenden Schicht (29,49,79,89) verbunden ist, und dass Elektroden der dazwischen liegenden Leuchtdiodenchips über Leiterbahnen (3, 23, 43, 73, 83) miteinander verbunden sind.

5. Leuchtpaneel nach Anspruch 4, **dadurch gekennzeichnet, dass** erste Leuchtdiodenchips (4a,4d,4k,4n,74a,84a) der Untereinheiten in die ersten Öffnungen (7,27,47,77) in der ersten isolierenden Schicht (2, 22, 42, 72, 82) auf der Unterlage (1,21,41,71,81) angebracht und über erste Elektroden durch diese kontaktiert sind, und dass weitere Leuchtdiodenchips (4b,4c,4e,4f,4g,4h,4i,4l,4m,4o,4p,74b,74c,74d,84b) der Untereinheiten auf einer der Leiterbahnen (3,23,43,73,83) angebracht und über erste Elektroden durch diese kontaktiert sind, wobei zweite Elektroden der letzten Leuchtdiodenchips (4c,4i,4m,4p,74d) der Untereinheiten durch die elektrisch leitende Schicht (29,49,79,89) kontaktiert sind, und wobei zweite Elektroden der übrigen Leuchtdiodenchips der Untereinheiten mit der Leiterbahn des jeweils nächsten Leuchtdiodenchips der Untereinheit kontaktiert sind.

6. Leuchtpaneel nach Anspruch 5, **dadurch gekennzeichnet, dass** die Leuchtdiodenchips trotz der fest vorgegebenen Abstände der ersten Öffnungen (7,27,47,77) in der ersten isolierenden Schicht (2,22,42,72,82) und der **dadurch** ebenfalls vorgegebenen beschränkten Länge der Leiterbahnen (3,23,43,73,83) zur seriellen elektrischen Verbindung der Leuchtdiodenchips einer Untereinheit, in nicht uniformen Abständen angeordnet sind, indem die Leuchtdiodenchips mindestens einer Untereinheit nicht bei jeder ersten Öffnung (7,27,47,77) in der ersten isolierenden Schicht (2,22,42,72,82), sondern nur bei jeder x-ten, d.h. bei jeder zweiten, dritten usw., oder einer anderen Folge mit beliebig wechselnden Abständen, angebracht sind, und indem die **dadurch** vorhandenen elektrischen Unterbrüche zwischen den dazwischen liegenden Leiterbahnen (3,23,43,73,83) zur seriellen elektrischen Verbindung mittels eines Leiterbahn-Kontaktmittels (8) überbrückt sind.

7. Leuchtpaneel nach einem der Ansprüche 2 bis 6, **gekennzeichnet durch**, eine zweite elektrisch isolierende Schicht (28, 48) **durch** welche die Leiterbahnen (3,23,43,73,83)und die elektrisch leitende Schicht (29, 49, 79, 89) voneinander elektrisch isoliert sind, wobei die Leiterbahnen mindestens teilweise zwischen der ersten elektrisch isolierenden Schicht (2,22,42,72,82) und der zweiten elektrisch isolierenden Schicht (28,48) verlaufen.

8. Leuchtpaneel nach einem der Ansprüche 2 bis 7, **gekennzeichnet durch** zusätzliche elektrische Bauelemente (9,10), wie beispielsweise Widerstände, die zu einzelnen oder einer Gruppe von Leuchtdiodenchips (4,24,44,74,84) einer gesamten elektrisch seriell verbundenen Untereinheit parallel oder seriell geschaltet sein können.

9. Leuchtpaneel nach einem Ansprüche 2 bis 8, **dadurch gekennzeichnet, dass** die Unterlage (1,21,41,71,81) Strukturen zur Wärmeabfuhr, beispielsweise Kühlrippen (1a), aufweist oder auf einem mechanischen Träger mit Strukturen zur Wärmeabfuhr aufgebracht ist.

10. Leuchtpaneel nach einem der Ansprüche 2 bis 9, **dadurch gekennzeichnet, dass** mindestens einige der Leuchtdiodenchips (4,24,44,74,84) Blaulicht- oder Violettlicht- oder Ultraviolettlicht-Leuchtdiodenchips sind.

11. Leuchtpaneel nach einem der Ansprüche 2 bis 10 **gekennzeichnet durch** mindestens eine mindestens teilweise lichtdurchlässige Zusatzschicht (30,31,32,50,51,60,93,94), welche so angeordnet ist, dass sich die Leuchtdiodenchips (4,24,44,74,84) zwischen der Unterlage (1,21,41,71,81) und der Zusatzschicht befinden oder in die Zusatzschicht eingegossen sind.

12. Leuchtpaneel nach Anspruch 11, **dadurch gekennzeichnet, dass** die Zusatzschicht bzw. mindestens eine Zusatzschicht (30,31,32,50,51,60,93,94) transparent und mit reflektierenden Partikeln und/oder in Bereichen oberhalb der Leuchtdiodenchips mit optischen Elementen oder Strukturen (53, 63,64,93b) zur Ausrichtung und/oder Verteilung von Licht versehen ist.

13. Leuchtpaneel nach einem der Ansprüche 11 oder 12 **dadurch gekennzeichnet, dass** die Zusatzschicht bzw. mindestens eine Zusatzschicht (30,31,32,50,51,60,93,94) mit sekundär emittierendem Farbstoff versehen ist.

14. Leuchtpaneel nach Anspruch 13, **dadurch gekennzeichnet, dass** die Zusatzschicht mit sekundär emittierendem Farbstoff im Wesentlichen flach ist und eine Mehrzahl von Leuchtdiodenchips (4,24,44,74,84) überdeckt.

15. Leuchtpaneel nach Anspruch 13 oder 14, **dadurch gekennzeichnet, dass** die Zusatzchicht bzw. mindestens eine Zusatzschicht (30,31,32,50,51,60,93,94) als Abdeckschicht ausgebildet ist und so auf der die Leuchtdiodenchips tragenden Leiterplatte angebracht ist, dass sie mechanisch von den Leuchtdiodenchips (14,24,44,74,84) entkoppelt ist, wobei zwischen der Leiterplatte und der Abdeckschicht vorzugsweise Abstandhaltemittel (92b) vorhanden sind.

16. Leuchtpaneel nach Anspruch 15, **dadurch gekennzeichnet, dass** die mit sekundär emittierendem Farbstoffverschene Zustatzschicht auf der den Leuchtdiodenchips (4,24,44,74,84), zugewandten Seite der Abdeckschicht oder zwischen mindenstens zwei die Abdeckschicht bildenden Zusatzschichten aufgebracht ist.

17. Leuchtpaneel nach Anspruch 15 oder 16, **dadurch gekennzeichnet, dass** die Abdeckschicht in Bereichen oberhalb der Leuchtdiodenchips (4,24,44,74,84) optische Elemente aufweist (93b), bspw. Fresnel-Linsen oder Strukturen mit so reflektierenden Flächen, dass eine Richtwirkung entsteht.

18. Leuchtpaneel nach einem der Ansprüche 2 bis 17, **dadurch gekennzeichnet, dass** die Unterlage ein regelmässiges Raster an Vertiefungen (91a,91b) aufweist, in welchen die bzw. mindestens einige Leuchtdiodenchips angebracht sind.

19. Leuchtpaneel nach Anspruch 18, **dadurch gekennzeichnet, dass** die Vertiefungen (91a,91b) mit einer als Reflektorschicht fungierenden Beschichtung versehen sind und dass sie bspw. kugelschalenförmig oder als Paraboloid mit einer flachen Zone ausgebildet sind.

20. Leuchtpaneel nach einem der Ansprüche 2 bis 19, **dadurch gekennzeichnet, dass** es frei von organischen Materialien ist.

## Claims

1. Carrier plate for use as a component of a light-emitting panel, comprising
● a base layer (1, 21, 41, 71, 81) with an electrically conducting surface,
● and a thereto applied first electrically insulating layer (2, 22, 42, 72, 82) having a regular raster of first apertures (7, 27, 47, 77),
● a regular grid arrangement of conductor paths (3, 23, 43, 73, 83) being electrically insulated from said base layer (1, 21, 41, 71, 81) by said first electrically insulating layer (2, 22, 42, 72, 82),
● wherein said first apertures are arranged at crossing points of said grid arrangement of conductor paths (3, 23, 43, 73, 83) and said conductor path (3, 23, 43, 73, 83) are interrupted at these crossing points,
● as well as an electrically conducting layer (29, 49, 79, 89) being electrically insulated from said base layer (1, 21, 41, 71, 81) and said conductor paths (3, 23, 43, 73, 83) having a regular raster of second apertures, which comprise said first apertures and are larger sized than those.

2. Light-emitting panel with a carrier plate according to claim 1, as well as with minimal-sized sub-units each comprising at least two serially connected luminous bodies (4, 24, 44, 74, 84) mounted on said carrier plate and being operable with electricity,
● wherein said luminous bodies (4, 24, 44, 74, 84) of the smallest sub-units are electrically connected in series by said conductor paths (3, 23, 43, 73, 83),
● wherein said smallest sub-units are electrically connected in parallel among each other, so that part units of the LED-luminous panel, comprising at least one or more of the minimal-sized sub-units, form an operative, separable LED-luminous panel itself, and
● wherein said base layer (1, 21, 41, 71, 81) and said electrically conducting layer (29, 49, 79, 89) function as connection surfaces thus electrically connecting said sub-units in parallel.

3. The light-emitting panel according to claim 2, wherein at least some of said luminous bodies (4, 24, 44, 74, 84) are directly placed on one of said conductor paths (3, 23, 43, 73, 83) and are contacted by those.

4. The light-emitting panel according to claim 2 or 3 wherein each said luminous body (4, 24, 44, 74, 84) comprises a first and a second electrode, wherein said first electrodes of each first luminous body (4a, 4d, 4k, 4n, 74a, 84a) in each sub-unit are electrically contacted by said base layer (1, 21, 41, 71, 81), wherein said second electrode of each last luminous body (4c, 4i, 4m, 4p, 74d) in each sub-unit is connected to said electrically conducting layer (29, 49, 79, 89) by a contact means (5, 25, 45) and wherein said electrodes of said luminous bodies placed in between are connected among each other by said conductor paths (3, 23, 43, 73, 83).

5. The light-emitting panel according to claim 4, wherein said first luminous bodies (4a, 4d, 4k, 4n, 74a, 84a) of said sub-units are placed in said first apertures (7, 27, 47, 77) in said first insulating layer (2, 22, 42, 72, 82) on the base layer (1, 21, 41, 71, 81) and first electrodes are contacted among each other by said base layer (1, 21, 41, 71, 81) and that said other luminous bodies (4b, 4c, 4e, 4f, 4g, 4h, 4i, 41, 4m, 4o, 4p, 74b, 74c, 74d, 84b) of said sub-units are placed on one of said conductor paths (3, 23, 43, 73, 83) and first electrodes are contacted among each other by said base layer (1, 21, 41, 71, 81), wherein second electrodes of said last luminous bodies (4c, 4i, 4m, 4p, 74d) of said sub-units are contacted by said electrically conducting layer (29, 49, 79, 89) and wherein said second electrodes of the remaining luminous bodies of said sub-units contact with the strip conductor of each next luminous body of the sub-unit.

6. The light-emitting panel according to claim 5, wherein said luminous bodies, despite a predetermined grid spacing between said first apertures (7, 27, 47, 77) arranged in the first insulating layer (2, 22, 42, 72, 82) and also despite the accordingly predetermined restricted length of said conductor paths (3, 23, 43, 73, 83) for electrically connecting said luminous bodies of one sub-unit in series, are arranged in non-uniform distances by placing said luminous bodies of at least one sub-unit not in every first aperture (7, 27, 47, 77) in the first insulating layer (2, 22, 42, 72, 82) but only in every umpteenth, i.e. in every second, third, etc., or any other sequence with changing distances and in that the thus existing electrical interruptions between said conductor paths (3, 23, 43, 73, 83) lying there between for an electrical connection in series are bridged by way of conductor path contact means (8).

7. The light-emitting panel according to claims 2 to 6, wherein a second electrically insulating layer (28, 48) insulates said conductor paths (3, 23, 43, 73, 83) from said electrically conducting layer (29, 49, 79, 89), wherein said conductor paths (3, 23, 43, 73, 83) are at least partially embedded between said first electrically insulating layer (2, 22, 42, 72, 82) and said second electrically insulating layer (28, 48).

8. The light-emitting panel according to claims 2 to 7, wherein additional circuit components (9, 10), e.g. resistors, can be connected in series or in parallel to single luminous bodies or a group of luminous bodies (4, 24, 44, 74, 84) of a complete serially connected sub-unit.

9. The light-emitting panel according to claims 2 to 8, wherein said base layer (1, 21, 41, 71, 81) comprises structures for heat dissipation, e.g. cooling ribs (1a), or is mounted on a mechanical support comprising structures to dissipate heat.

10. The light-emitting panel according to claim 2 to 9, wherein at least some of said luminous bodies (4, 24, 44, 74, 84) are blue light or violet light or ultraviolet light emitting bodies (4, 24, 44, 74, 84).

11. The light-emitting panel according to claims 2 to 10, wherein at least one additional layer being at least partially translucent (30, 31, 32, 50, 51, 60, 93, 94) is arranged so that said luminous bodies (4, 24, 44, 74, 84) are arranged between said base layer (1, 21, 41, 71, 81) and said additional layer or are embedded into said additional layer.

12. The light-emitting panel according to claim 11, wherein said additional layer or at least one additional layer (30, 31, 32, 50, 51, 60, 93, 94) is translucent and comprises reflecting particles and/or optical elements or structures (53, 63, 64, 93b) in the area above the luminous bodies (4, 24, 44, 74, 84) for directing and/or distributing light.

13. The light-emitting panel according to claim 11 or 12, wherein said additional layer or at least one additional layer (30, 31, 32, 50, 51, 60, 93, 94) comprises a secondary emitting dye.

14. The light-emitting panel according to claim 13, wherein said additional layer provided with a secondary emitting pigment essentially is flat and covers a majority of light emitting bodies (4, 24, 44, 74, 84).

15. The light-emitting panel according to claim 13 or 14, wherein said additional layer or at least one additional layer (30, 31, 32, 50, 51, 60, 93, 94) forms a cover layer and is arranged on the carrier plate carrying the luminous bodies (4, 24, 44, 74, 84) so that it is mechanically disconnected from the luminous bodies (4, 24, 44, 74, 84), wherein between said carrier plate and said cover layer preferably space keeping means (92b) are arranged.

16. The light-emitting panel according to claim 15, wherein said additional layer provided with a secondary emitting pigment is arranged on the side of the cover layer facing the luminous bodies (4, 24, 44, 74, 84) or between at least two additional layers forming the cover layer.

17. The light-emitting panel according to claim 15 or 16, wherein said cover layer comprises optical elements (93b) in areas above the luminous bodies (4, 24, 44, 74, 84), for example Fresnel lenses or structures which reflect such that a directing effect arises.

18. The light-emitting panel according to claims 2 to 17, wherein said base layer comprises a regular raster of recesses (91a, 91b), into which said or at least some of said luminous bodies (4, 24, 44, 74, 84) are placed.

19. The light-emitting panel according to claim 18, wherein said recesses (91a, 91b) are coated thus functioning as a reflector layer and wherein said recesses are formed in the shape for example of a ball shell or as a paraboloid with a flat zone.

20. The light-emitting panel according to claims 2 to 19, wherein it is free of organic material.

## Revendications

1. Circuit imprimé pour l'utilisation comme composant dans un panneau lumineux, comportant:
● un support (1, 21, 41, 71, 81) avec une surface conductrice,
● et une première couche isolante (2, 22, 42, 72, 82) avec une grille régulière de premières ouvertures (7, 27, 47, 77),
● des pistes conductrices (3, 23, 43, 73, 83) régulièrement placées en forme d'une grille, lesquelles sont isolées du support par la première couche isolante (2, 22, 42, 72, 82),
● où les premières ouvertures au points de croisement de la grille de pistes conductrices sont placées et les pistes conductrices (3, 23, 43, 73, 83) sont interrompues à ces points de croisement,
● ainsi que d'une couche conductrice (29, 49, 79, 89) étant isolée du support (1, 21, 41, 71, 81) et des pistes conductrices (3, 23, 43, 73, 83) avec une grille régulière de deux ouvertures, lesquelles enclosent les premières ouvertures et sont plus grandes.

2. Panneau luminescent avec un circuit imprimé selon revendication 1, ainsi qu'avec des plus petites unités secondaires équipées au moins avec deux microplaquettes de diodes lumineuses (4, 24, 44, 74, 84),
● où les microplaquettes de diodes lumineuses (4, 24, 44, 74, 84) de plus petites unités secondaires sont connectées électriquement en série par des pistes conductrices (3, 23, 43, 73, 83),
● où les plus petites unités secondaires sont connectées en parallèle entre eux, de sorte que des parties du panneau luminescent, enclosant une ou plusieurs de plus petites unités secondaires, formant des panneaux luminescents séparables et fonctionnant indépendamment,
● et où le support (1, 21, 41, 71, 81) et la couche conductrice (29, 49, 79, 89) servent comme de surfaces de connexion pour la mise en contact électrique et parallèle des unités secondaires.

3. Panneau luminescent selon revendication 2, **caractérisé en ce qu'**au moins quelques microplaquettes de diodes lumineuses (4, 24, 44, 74, 84) sont placées sur une des piste conductrices (3, 23, 43, 73, 83) et sont connectées avec ces piste conductrices (3, 23, 43, 73, 83).

4. Panneau luminescent selon revendications 2 et 3, **caractérisé en ce que** chaque microplaquette de diodes lumineuses (4, 24, 44, 74, 84) possède une première et une deuxième connexion électrique, que les premières connexions électriques de chaque première microplaquette de diodes lumineuses (4a, 4d, 4k, 4n, 74a, 84a) de chaque unité secondaire sont connectées électriquement par le support (1, 21, 41, 71, 81), que la deuxième connexion électrique de chaque dernière microplaquette de diodes lumineuses (4c, 4i, 4m, 4p, 74d) de chaque unité secondaire est connectée avec la couche conductrice (29, 49, 79, 89) à l'aide d'un moyen de contact (5, 25, 45) et que des connexions électriques des microplaquettes de diodes lumineuses, étant placées entre eux sont connectées à l'aide de pistes conductrices (3, 23, 43, 73, 83).

5. Panneau luminescent selon revendication 4, **caractérisé en ce que** des premières microplaquettes de diodes lumineuses (4a, 4d, 4k, 4n, 74a, 84a) des unités secondaires sont placées dans les premières ouvertures (7, 27, 47, 77) de la première couche isolante ( 2, 22, 42, 72, 82 ) placée sur le support (1, 21, 41, 71, 81) et étant connectées à l'aide des premières connexions électriques et que d'autres microplaquettes de diodes lumineuses (4b, 4c, 4^{e}, 4f, 4g, 4h,4i, 41, 4m, 4o, 4p, 74b, 74c, 74d, 84b) des unités secondaires sont placées sur une des pistes conductrices (3, 23, 43, 73, 83) et étant connectées avec eux à l'aide de premières connexions électriques, où des deuxièmes connexions électriques des dernières microplaquettes de diodes lumineuses (4c, 4i, 4m, 4p, 74d) des unités secondaires sont connectées par la couche conductrice (29, 49, 79, 89) et où des deuxièmes connexions électriques des microplaquettes de diodes lumineuses restantes des unités secondaires sont connectées respectivement avec les pistes conductrices de la prochaine microplaquette de diodes lumineuses des unités secondaires.

6. Panneau luminescent selon revendication 5, **caractérisé en ce que** les plaquettes de diodes lumineuses (4, 24, 44, 74, 84) malgré des distances fixes des premières ouvertures (7, 27, 47, 77) de la couche isolante (2, 22, 42, 72, 82) et à cause de cela aussi la limitation des longueurs des pistes conductrices (3, 23, 43, 73, 83) pour une connexion électrique sérielle des microplaquettes de diodes lumineuses d'une unité secondaire sont placées en distances non-uniformes, cependant les microplaquettes de diodes lumineuses, au moins d'une unité secondaire, ne sont pas placées au niveau de chaque première ouverture (7, 27, 47, 77) dans la première couche isolante mais seulement au niveau de chaque x-ème, c'est-à-dire, au niveau de chaque deuxième, troisième et ainsi de suite, ou d'une autre suite avec des distances changeables librement et cependant les discontinuités électriques existantes, étant placées entre les pistes conductrices (3, 23, 43, 73, 83), sont connectées pour une sérielle connexion électrique à l'aide d'un moyen de contact (8) pour des pistes conductrices.

7. Panneau luminescent selon revendications 2 et 6, **caractérisé en ce qu'**une deuxième couche isolante (28, 48) sépare électriquement les pistes conductrices (3, 23, 43, 73, 83) et la couche conductrice (29, 49, 79, 89), où les pistes conductrices se trouvent au moins partiellement entre la première couche isolante (2, 22, 42, 72, 82) et la deuxième couche isolante (28, 48).

8. Panneau luminescent selon revendications 2 et 7, **caractérisé en ce que** des composants électriques complémentaires (9, 10), comme par exemple des résistances, peuvent être montés en parallèle ou en série seule ou en groupe de microplaquettes de diodes lumineuses (4, 24, 44, 74, 84) d'une unité secondaire entière, étant connectée électriquement en série.

9. Panneau luminescent selon revendications 2 et 8, **caractérisé en ce que** le support (1, 21, 41, 71, 81) possède des structures pour la dissipation de chaleur, par exemple des ailettes de refroidissement (1a), ou étant placé sur une couche dorsale mécanique avec des structures pour la dissipation de chaleur.

10. Panneau luminescent selon revendications 2 et 9, **caractérisé en ce qu'**au moins quelques unes des microplaquettes de diodes lumineuses sont des microplaquettes de diodes lumineuses (4, 24, 44, 74, 84) à lumière bleue, violette ou ultraviolette.

11. Panneau luminescent selon revendications 2 et 10, **caractérisé en ce qu'**il existe au moins une couche complémentaire (30, 31, 32, 50, 51, 60, 93, 94), étant au moins partiellement transparente, est placée d'une telle manière, que les microplaquettes de diodes lumineuses (4, 24, 44, 74, 84) se trouvent entre le support (1, 21, 41, 71, 81) et la couche complémentaire (30, 31, 32, 50, 51, 60, 93, 94) ou étant coulées dans la couche complémentaire.

12. Panneau luminescent selon revendication 11, **caractérisé en ce que** la couche complémentaire ou au moins d'une couche complémentaire (30, 31, 32, 50, 51, 60, 93, 94) est transparente et respectivement équipée avec des particules réfléchissantes et/ou dans les zones au-dessus des microplaquettes de diodes lumineuses (4, 24, 44, 74, 84) avec des éléments optiques ou des structures (53, 63, 64, 93b), pour la direction et/ou la distribution de la lumière.

13. Panneau luminescent selon revendications 11 ou 12, **caractérisé en ce que** la couche complémentaire respectivement au moins une couche complémentaire (30, 31, 32, 50, 51, 60, 93, 94) est équipée avec une matière colorante à émission secondaire.

14. Panneau luminescent selon revendication 13, **caractérisé en ce que** la couche complémentaire avec la matière colorante à émission secondaire est en général plate et couvre le plus grand nombre des microplaquettes de diodes lumineuses (4, 24, 44, 74, 84).

15. Panneau luminescent selon revendications 13 et 14, **caractérisé en ce que** la couche complémentaire respectivement au moins une couche complémentaire (30, 31, 32, 50, 51, 60, 93, 94) est formée comme chape et est fixée de telle manière sur le circuit imprimé portant les microplaquettes de diodes lumineuses (4, 24, 44, 74, 84), pour qu'elle soit mécaniquement découplée des microplaquettes de diodes lumineuses (4, 24, 44, 74, 84) où de préférence des moyens d'écartement (92b) existent entre le circuit imprimé et la chape.

16. Panneau luminescent selon revendication 15, **caractérisé en ce que** la couche complémentaire équipée d'une matière colorante à émission secondaire est placée en face de la chape des microplaquettes de diodes lumineuses (4, 24, 44, 74, 84) ou au moins entre deux des couche complémentaires formant la chape.

17. Panneau luminescent selon revendications 15 et 16, **caractérisé en ce que** la chape possède dans les zones au-dessus des microplaquettes de diodes lumineuses (4, 24, 44, 74, 84) des éléments optiques (93b) respectivement des lentilles de Fresnel ou des structures avec des surfaces réfléchissantes créant une directivité.

18. Panneau luminescent selon revendications 2 et 17, **caractérisé en ce que** le support possède une grille régulière de creux (91a, 91b) dans lesquels respectivement les ou au moins quelques microplaquettes de diodes lumineuses (4, 24, 44, 74, 84) sont placées.

19. Panneau luminescent selon revendication 18, **caractérisé en ce que** les creux (91a, 91b) sont équipés d'une chape constituant la couche réfléchissante et qu'ils ont respectivement la forme sphérique ou paraboloïde avec une zone plate.

20. Panneau luminescent selon revendications 2 et 19, **caractérisé en ce que** le panneau luminescent n'est pas constitué des matériaux organiques.
